(19)

Europäisches
Patentamt
European
Patent Office
Office européen
des brevets

(11) **EP 2 544 014 A1**

(12) **EUROPEAN PATENT APPLICATION**

(43) Date of publication:
**09.01.2013 Bulletin 2013/02**

(51) Int Cl.:
*G01R 31/08* *(2006.01)*

(21) Application number: **11460033.1**

(22) Date of filing: **05.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventors:
• **Balcerek, Przemyslaw**
**30-389 Krakow (PL)**

• **Saha, Murari**
**722 24 Vasteras (SE)**
• **Rosolowski, Eugeniusz**
**52-403 Wroclaw (PL)**
• **Izykowski, Jan**
**50-306 Wroclaw (PL)**
• **Pierz, Piotr**
**50-311 Wroclaw (PL)**

(74) Representative: **Chochorowska-Winiarska, Krystyna**
**ABB Sp. z o. o.,**
**Ul. Zeganska 1**
**04-713 Warszawa (PL)**

(54) **A method of selecting between faulted and healthy circuits in parallel lines using one-end measurements**

(57)     The present invention is concerned with a selection between faulted and healthy circuits in parallel lines, using one-end measurements in electric power lines, applicable to parallel power lines, fit for use in the power industry for overhead transmission lines. The subject of the inventive method using measurement of current signals at one end of the line in terminal A or in terminal B, processing measuring data, determination of pre-fault and fault current signals and the zero-sequence current signal, obtaining current phasors ($I_{A1}$, $I_{B1}$, $I_{C1}$, $I_{A2}$, $I_{B2}$, $I_{C2}$, $I_{01}$, $I_{02}$), consists in that the method further comprises the steps of:
- determination of a symmetrical scaling coefficient ($k_{prefault}$) establishing a reciprocal relation between the currents of a single line of the parallel lines,
- determination of the corrected fault current phasors after scaling and calculation of current differences sum for each line ($sdi1$, $sdi01$, $sdi2$, $sdi02$),
- determination of fault $f_1$, $fi_{01}$, $f_2$, $f_{02}$ coefficients ,
- determination of the value of flags $ff_1$ and $ff_2$ having a conventional value one or zero and a selection of faulted and healthy circuits in the parallel lines.

Fig. 2

EP 2 544 014 A1

**Description**

The present invention relates to a selection between faulted and healthy circuits in parallel lines with the use of one-end measurements in electric power lines, applicable to parallel power lines, fit for use in the power industry for overhead transmission lines.

Series compensation (SC) is applied to worldwide EHV transmission lines where long transmission distance and large power transmission are involved. It is an effective and economic means of increasing power transmission capability, improving power system stability, reducing transmission losses, enhancing voltage control and flexible power flow control.

However, protection of such kind of line still causes problems especially for parallel lines. This is due to the fact that series capacitors shift the fault-loop impedances which results in tripping the healthy line. Additionally, the currently used algorithms aimed at identifying the fault direction maloperate in the case of inversion of voltage and current signals.

To avoid such misoperation, the present practice relies on using traditional distance relays but with modified settings. Considerable shortening of the first zone reach to 30-40% instead of 85% is applied.

An example of a current application for detecting the position of a fault on a parallel lines link is described in the US patent 4525098. This application is based on determination of the fault direction in the protection relays located at each end of the parallel lines . If both relays located in one of the circuits of the parallel lines indicate the same forward fault direction, this circuit of the parallel lines is declared to be the faulted one.

Another example of a method for fault location in the parallel transmission lines with series compensation is described in US patent 6476613. In this solution the zero sequence current measurement is used to compensate the mutual impedance effect in distance-to-fault calculation.

The disadvantage of this method is that it requires the use of mutual impedance which is not uniformly distributed or known. The invented method does not use mutual impedance.

The invented method is designed to allow selection between faulted and healthy circuits in parallel lines. The input signals in the method are samples of three-phase currents from both circuits of the parallel lines. Due to the applied specific kind of measurements the delivered method is considered to be a simple and important supplementation of the distance relay protection of parallel lines aimed at fast switching-off of the faulty line.

The invented method can be used for both series compensated and uncompensated parallel transmission lines and it is also applicable in cases where one of the parallel lines works as series compensated and the other line of the parallel lines works as uncompensated.

The subject of the inventive method using measurement of current signals at one end of the line in terminal A or in terminal B, processing the measuring data, determination of the pre-fault and fault current signals and the zero-sequence current signal, obtaining current phasors $(I_{A1}, I_{B1}, I_{C1}, I_{A2}, I_{B2}, I_{C2}, I_{01}, I_{02})$ consists in that the method further comprises the steps of:

- determination of the symmetrical scaling coefficient $(k_{prefault})$ establishing a reciprocal relation between the currents of the single line of the parallel lines,
- determination of the corrected fault current phasors after scaling and calculating the current differences sum for each line $(sdi1, sdi01, sdi2, sdi02)$,
- determination of fault $f_1$, $f_{i01}$, $f_2$, $f_{02}$ coefficients
- determination of the value of flags $ff_1$ and $ff_2$ having a conventional value of one or zero in order to carry out the selection of faulted and healthy circuits in the parallel lines when the following conditions are fulfilled:

for Line #1

$$ff_1(n) = \begin{cases} 1 & when & \begin{cases} f_1(n) \geq f_{thr} & AND & FAULT\_Ph-Ph_1(n)=1 \\ & OR & \\ f_{01}(n) \geq f_{thr} & AND & FAULT\_Ph-G_1(n)=1 \end{cases} \\ 0 & otherwise \end{cases}$$

for Line #2 (Circuit #2):

$$ff_2(n) = \begin{cases} 1 & when \\ 0 & otherwise \end{cases} \begin{cases} f_2(n) \geq f_{thr} & AND \quad FAULT\_Ph - Ph_2(n) = 1 \\ & OR \\ f_{02}(n) \geq f_{thr} & AND \quad FAULT\_Ph - G_2(n) = 1 \end{cases}$$

where:

$f_{thr}$ - threshold for fault *coefficients* $f_1$, $f_{i01}$, $f_2$, $f_{02}$
*FAULT_Ph - $G_1$ (n)* is a fault type coefficient indicating phase-to-ground faults and in the line #1
*FAULT_Ph - $Ph_1$ (n)* is a fault type coefficient indicating phase-to-phase fault in the line #1 or non-fault conditions,
*FAULT_Ph - $G_2$ (n)* is a fault type coefficient indicating phase-to-ground faults and in the line #2,
*FAULT_Ph - $Ph_2$ (n)* is a fault type coefficient indicating a phase-to-phase fault in the line #2 or non-fault conditions.

Next the selection is performed in the following actions.
First it is checked if only one of the flags $ff_1$ or $ff_2$ equals one, and if :

$$ff_1(n) = 1 \;\; AND \;\; ff_2(n) = 1 \quad then \;\; ff_1(n) = 0 \;\; AND \;\; ff_2(n) = 0,$$

$$or$$

$$ff_1(n) = 0 \;\; AND \;\; ff_2(n) = 0,$$

it means that the outside fault of the parallel lines has been identified.
Next the relation between the value of the $ff_1$ and $ff_2$ is checked, and if

$$ff_1(n) = 1 \;\; AND \;\; ff_2(n) = 0 ,$$

it means that internal fault within line # 1 of the parallel lines has been identified; or if

$$ff_1(n) = 0 \;\; AND \;\; ff_2(n) = 1,$$

it means that internal fault within line # 2 of the parallel lines has been identified.
In the embodiment of the invention the threshold for coefficients $f_1$, $f_{i01}$, $f_2$, $f_{02}$ was set to ($f_{thr}$ = 1.5).
A computer program product comprising a computer program code which when executed on a data processor unit of a protective device carries out the steps of the method according to claims 1-2.
The subject of the inventive system having a protective device with a processor located at one end of the parallel lines and with a functional module for storing data delivered from an on-line measurement, with a calculating module for doing calculation operations and with an information module for presenting the result of the inventive method, is that the protective device has a selection module for performing the actions according to any of the method claims. Preferably the protective device has a form of a protective relay.
The inventive method is used in a protective device having the form of a protective relay. A real-time digital current signal coming from current transformers and converted in an A/D converter into a digital signal compatible with IEC 61850 standard, is transmitted by the IEC 61850 9-2 protocol or any other communication protocol. The conversion of analogue phase current signals with the aid of the current instrument transformer CT's allows to obtain sampled discrete time values. In this context, interconnection by means of a station communication protocol preferably compatible with the IEC 61850 standard should be regarded as conventional techniques and have therefore been omitted.
The present invention relates to a method for selecting between internal and external faults in parallel lines using one-end current signal measurements from both circuits of the parallel lines. Thanks to the inventive approach high reliability of identification of internal and external faults in parallel lines with the use of one-end measurements is achieved.

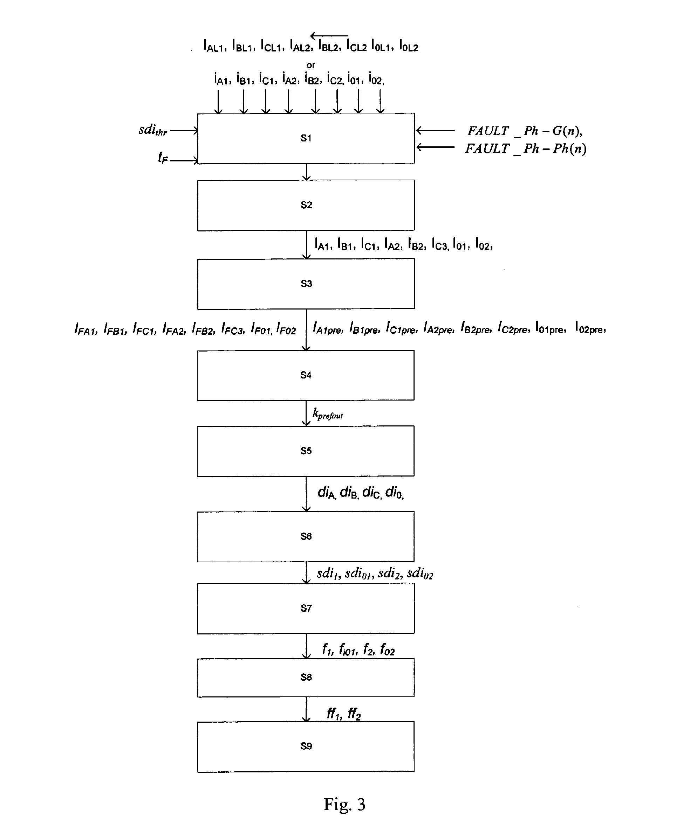

A method of selecting between internal and external faults in parallel lines is presented in the drawing, where fig. 1 shows the schematic system for selecting between internal and external faults in parallel lines with the use of one-end measurements, fig. 2 - the inventive part of the system for selecting between internal and external faults in parallel lines with the use of one-end measurements in a protection relay, fig. 3 - a set of steps for the realisation of the inventive method.

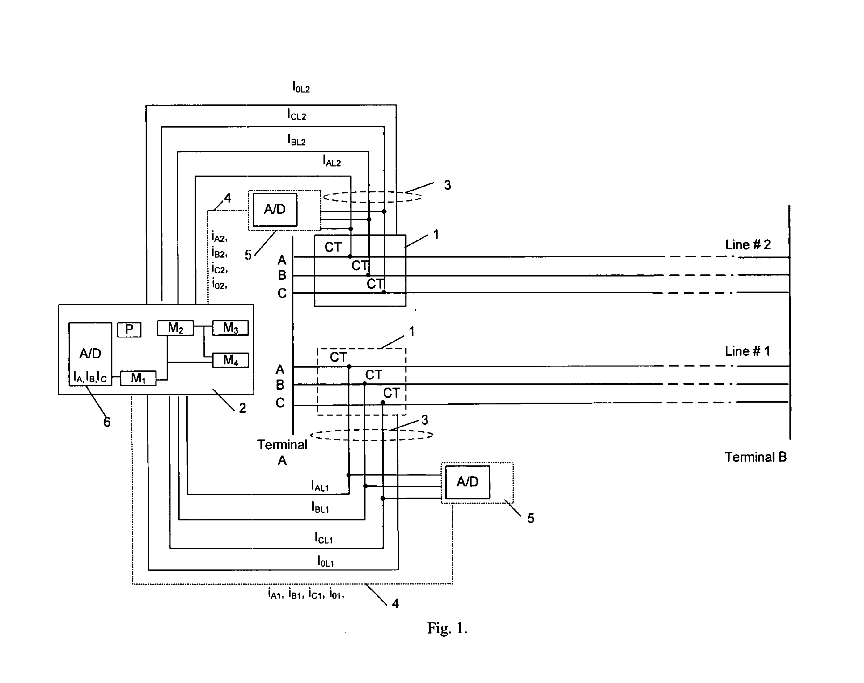

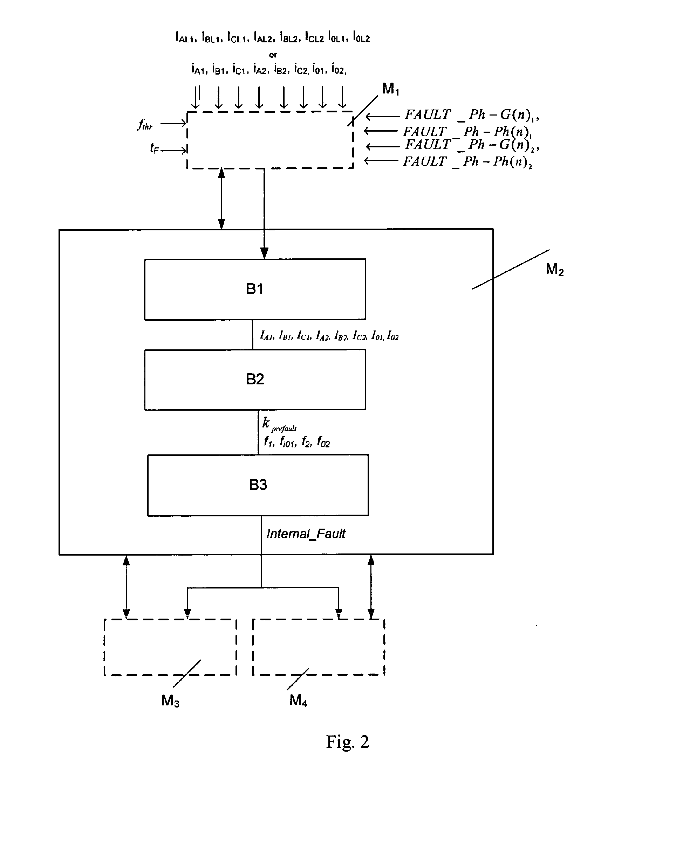

In two parallel lines Line #1 and Line #2 current transformers 1 are connected with a protective device 2, having a form of a protection relay, by an analogue wire link 3 or by means of a process communication bus 4 containing a Margin Unit 5. The protection relay 2 with a data processing unit P comprises an A/D converter 6 and an arrangement of functional modules M1, M2, M3, M4 where the module M1 is a buffer module for storing data delivered from an on-line measurement, the module M2 is the module of selection between internal and external faults, the module M3 is a calculating module connecting with the others modules, and the module M4 is an information module for giving the result of the inventive method. In a case where the protection relay 2 is connected by the communication bus 4, the A/D converter 6 may be located in the Margin Unit 5 instead of being in the protection relay 2, which is indicated on the drawing by the dotted line. It is obvious that the protection relay 2 comprises other modules which are essential for the proper operation of the protection relay and which are not described in the description, and not presented in the fig. 1. The module M2 of the selection between internal and external faults in parallel lines, presented in fig. 2, comprises a pre-filtering block B1 for filtering digital current signals, a data analysis block B2 for processing digital current signals, and a decision block B3 for selecting between internal and external faults in the parallel lines.

The method according to the invention is carried out in the following steps:

STEP 1 - gathering input measurements and settings

In Step S1, real-time analog current signals $I_{AL1}$, $I_{BL1}$, $I_{CL1}$, $I_{AL2}$, $I_{BL2}$, $I_{CL2}$ from the individual phases A, B, C from both circuit of the parallel lines Line #1 and Line #2 and optional zero sequences currents of both circuits of the parallel lines $I_{0L1}$, $I_{0L2}$ are measured in the current transformers. Next, the measured data are converted in an A/D converter to digital current signals $i_{A1}$, $i_{B1}$, $i_{C1}$, $i_{A2}$, $i_{B2}$, $i_{C2}$, $i_{01}$, $i_{02}$. and stored in the buffer module M1 of the protection relay.

Additionally a fault type coefficient $FAULT\_Ph - G_1 (n)$ indicating phase-to-ground faults and in the line #1 coefficient $FAULT\_Ph - Ph_1 (n)$ indicating a phase-to-phase fault in the line #1, coefficient $FAULT\_Ph - G_2 (n)$ indicating phase-to-ground faults and in the line #2 coefficient $FAULT\_Ph - Ph_2 (n)$ indicating a phase-to-phase fault in the line #2, and a fault detection time $t_F$, are taken from other essential modules required for the proper operation of the protection relay. Also in this step a different current sum coefficient $sdi_{thr}$ indicating a threshold value is delivered to the relay by the user. All of those coefficients are stored in the buffer module M1 of the protection relay.

If during the operation of the parallel lines, a phase-to-ground fault occurs in line #1, then the coefficient $FAULT\_Ph - G_1 (n) = 1$ and the coefficient $FAULT\_Ph - Ph_1 (n) = 0$. If during the operation of the parallel lines a phase-to-phase fault occurs in line #1 then the coefficient $FAULT\_Ph - G_1 (n) = 0$ and the coefficient $FAULT\_Ph - Ph_1 (n) = 1$. When a phase-to-phase-to-ground fault occurs both $FAULT\_Ph - G_1 (n)$ and $FAULT\_Ph - Ph_1 (n)$ are set to 1.

If during the operation of the parallel lines, a phase-to-ground fault occurs in line #2, then the coefficient $FAULT\_Ph - G_2 (n) = 1$ and the coefficient $FAULT\_Ph - Ph_2 (n) = 0$ . If during the operation of the parallel lines a phase-to-phase fault occurs in line #1, then the coefficient $FAULT\_Ph - G_2 (n) = 0$ and the coefficient $FAULT\_Ph - Ph_2 (n) = 1$. When a phase-to-phase-to-ground fault occurs, both $FAULT\_Ph - G_2 (n)$ and $FAULT\_Ph - Ph_2 (n)$ are set to 1.

STEP 2 - Filtering data

Next, in step S2 in the pre-filtering block B1, digital current signals from individual phases $i_{A1}$, $i_{B1}$, $i_{C1}$, $i_{A2}$, $i_{B2}$, $i_{C2}$ of both circuit of the parallel lines and zero sequences currents $i_{01}$, $i_{02}$ are filtered using one of the known methods of half-period filtering, for example the half-period window Fourier filter method, in order to obtain the phasor value of digital current signals $I_{A1}$, $I_{B1}$, $I_{C1}$, $I_{A2}$, $I_{B2}$, $I_{C2}$ for each individual phase A, B, C of both circuits of the parallel lines , which are represented by magnitude and phase angle. Also zero sequences digital currents $I_{0L1}$, $I_{0L2}$ of both circuits of the parallel lines are filtered in order to obtain the phasor value $I_{01}$ and $I_{02}$. Alternatively, if the zero sequence currents $I_{0L1}$ and $I_{0L2}$ are not measured and delivered in step 1, the phasor value of zero sequences digital currents $I_{01}$, $I_{02}$ can be calculated from the digital current signal according to the following formulas:

$$I_{01} = \frac{1}{3}\left(I_{A1} + I_{B1} + I_{C1}\right),$$

$$I_{02} = \frac{1}{3}\left(I_{A2} + I_{B2} + I_{C2}\right),$$

where:

$I_{A1}$, $I_{B1}$, $I_{C1}$, - A, B, C phasor value of digital current signals in Line #1,
$I_{A2}$, $I_{B2}$, $I_{C2}$,- A, B, C phasor value of digital current signals in Line #2.

STEP 3 - Determination of pre-fault and fault current signals

In step S3, having the phasor value of digital current signals $I_{A1}$, $I_{B1}$, $I_{C1}$, $I_{A2}$, $I_{B2}$, $I_{C2}$, the pre-fault current signals $I_{A1pre}$, $I_{B1pre}$, $I_{C1pre}$, $I_{A2pre}$, $I_{B2pre}$, $I_{C2pre}$, $I_{01pre}$, $I_{02pre}$, and fault current signals $I_{FA1}$, $I_{FB1}$, $I_{FC1}$, $I_{FA2}$, $I_{FB2}$, $I_{FC2}$, $I_{F01}$, $I_{F02}$ are determined using any of the known method, with the use of the fault detection time $t_F$ delivered in step 1. In the embodiment of the invention the pre-fault current signals are determined using the one period length pre-fault current signals in the pre-filtering block B1.

STEP 4 - Determination of the symmetrical scaling coefficient

In step S4, first, having the pre-fault current signals $I_{A1pre}$, $I_{B1pre}$, $I_{C1pre}$, $I_{A2pre}$, $I_{B2pre}$, $I_{C2pre}$, the average values of 3-phase digital current signals magnitude $I_{ABC1pre}$, , $I_{ABC2pre}$, of both circuits of the parallel lines are calculated in the data analysis block B2 as:

$$I_{ABC1pre} = \frac{1}{3}\left\||I_{A1}| + |I_{B1}| + |I_{C1}|\right\|$$

$$I_{ABC2pre} = \frac{1}{3}\left\||I_{A2}| + |I_{B2}| + |I_{C2}|\right\|$$

Next, the symmetrical scaling coefficient $k_{prefault}$ is determined according to the following formula:

$$k_{prefault} = \frac{|I_{ABC1pre}|}{|I_{ABC2pre}|}$$

STEP 5 - Calculation of the difference values of the corrected fault during the fault.

In the step S5 in the data analysis block B2, the corrected values of current phasors $I_{A1f}$, $I_{B1f}$, $I_{C1f}$, $I_{A2f}$, $I_{B2f}$, $I_{C2f}$ are determined assuming that fault currents from one of the line (Line #1 or Line #2) are taken as reference corrected values of current phasors according to the following formulas:

● if the reference line is the Line # 1 then:

$$I_{A1f}(n) = I_{FA1}(n), \quad I_{B1f}(n) = I_{FB1}(n), \quad I_{C1f}(n) = I_{FC1}(n), I_{01f}(n) = I_{F01}(n)$$

$$I_{A2f}(n) = k_{prefault} * I_{FA2}(n), \quad I_{B2f}(n) = k_{prefault} * I_{FB2}(n), \quad I_{C2f}(n) = k_{prefault} * I_{FC2}(n),$$

$$I_{02f}(n) = I_{F02}(n)$$

where:

n- is the real consecutive number of the present digital sample processed by the relay

● if the reference line is the Line # 2 then

$$I_{A2f}(n) = I_{FA2}(n), \quad I_{B2f}(n) = I_{FB2}(n), \quad I_{C2f}(n) = I_{FC2}(n), \quad I_{02f}(n) = I_{F02}(n)$$

$$I_{A1f}(n) = 1/k_{prefault} * I_{FA1}(n), \quad I_{B1f}(n) = 1/k_{prefault} * I_{FB1}(n), \quad I_{C1f}(n) = 1/k_{prefault} * I_{FC1}(n)$$

$$I_{01f}(n) = I_{F01}(n)$$

where:

n- is the real consecutive number of the present digital sample processed by the relay.

Next, having the corrected values of the current phasors $I_{A1f}$, $I_{B1f}$, $I_{C1f}$, $I_{A2f}$, $I_{B2f}$, $I_{C2f}$, the pre-fault current signals $I_{A1pre}$, $I_{B1pre}$, $I_{C1pre}$, $I_{A2pre}$, $I_{B2pre}$, $I_{C2pre}$ and average value of 3 phase digital current signals magnitude $I_{ABC1pre}$, $I_{ABC2pre}$, the difference values of the corrected fault current $di_{A1}$, $di_{B1}$, $di_{C1}$, $di_{01}$, $di_{A2}$, $di_{B2}$, $di_{C2}$, $di_{02}$ are determined in the data analysis block B2 for each of the circuits of the parallel transmission line according to the following formulas:

for Line #1:

$$di_{A1}(n) = \left\| I_{A1f}(n) \right\| - \left| I_{A1pre} \right\|,$$

$$di_{B1}(n) = \left\| I_{B1f}(n) \right\| - \left| I_{B1pre} \right\|,$$

$$di_{C1}(n) = \left\| I_{C1f}(n) \right\| - \left| I_{C1pre} \right\|,$$

$$di_{01}(n) = \left\| I_{01f}(n) \right\| - \left| I_{01pre} \right\| \ ,$$

for Line #2

$$di_{A2}(n) = \left\| I_{A2f}(n) \right\| - \left| I_{A2pre} \right\|,$$

$$di_{B2}(n) = \left\| \left|I_{B2f}(n)\right| - \left|I_{B2pre}\right| \right\|,$$

$$di_{C2}(n) = \left\| \left|I_{C2f}(n)\right| - \left|I_{C2pre}\right| \right\|,$$

$$di_{02}(n) = \left\| \left|I_{02f}(n)\right| - \left|I_{02pre}\right| \right\|,$$

STEP 6 - Calculation of the current differences sum

In step 6, having the difference values of the corrected fault current $di_{A1}$, $di_{B1}$, $di_{C1}$, $di_{01}$, $di_{A2}$, $di_{B2}$, $di_{C2}$, $di_{02}$, the sums of the current differences $sdi_1$, $sdi_{01}$, $sdi_2$, $sdi_{02}$ are calculated in the data analysis block B2 according to the following formulas:

for n=1 and for Line #1:

$$sdi_1(n) = di_{A1}(n) + di_{B1}(n) + di_{C1}(n),$$

$$sdi_{01}(n) = di_{01}(n),$$

for n=1 and for Line #2:

$$sdi_2(n) = di_{A2}(n) + di_{B2}(n) + di_{C2}(n),$$

$$sdi_{02}(n) = di_{02}(n)$$

for n>1 and for Line #1

$$sdi_1(n) = sdi_1(n-1) + di_{A1}(n) + di_{B1}(n) + di_{C1}(n),$$

$$sdi_{01}(n) = sdi_{01}(n-1) + di_{01}(n)$$

for n>1 for and Line #2:

$$sdi_2(n) = sdi_2(n-1) + di_{A2}(n) + di_{B2}(n) + di_{C2}(n),$$

$$sdi_{02}(n) = sdi_{02}(n-1) + di_{02}(n)$$

STEP 7

In step S7, having the sum of the current differences $sdi_1$, $sdi_{01}$, $sdi_2$, $sdi_{02}$ the fault $f_1$, $f_{i01}$, $f_2$, $f_{02}$ coefficients are calculated according to the following formulas:

-   for Line #1:

$$f_1(n) = \begin{cases} \dfrac{sdi_1(n)}{sdi_2(n)} & when \quad sdi_2(n) \neq 0 \\ 1 & when \quad sdi_2(n) \approx 0 \end{cases}$$

$$f_{01}(n) = \begin{cases} \dfrac{sdi_{01}(n)}{sdi_{02}(n)} & when \quad sdi_{02}(n) \neq 0 \\ 1 & when \quad sdi_{02}(n) \approx 0 \end{cases}$$

-   for Line #2:

$$f_2(n) = \begin{cases} \dfrac{sdi_2(n)}{sdi_1(n)} & when \quad sdi_1(n) \neq 0 \\ 1 & when \quad sdi_1(n) \approx 0 \end{cases}$$

$$f_{02}(n) = \begin{cases} \dfrac{sdi_{02}(n)}{sdi_{01}(n)} & when \quad sdi_{01}(n) \neq 0 \\ 1 & when \quad sdi_{01}(n) \approx 0 \end{cases}$$

STEP 8

In the next step, having the fault $f_1$, $f_{i01}$, $f_2$, $f_{02}$ coefficients and coefficient the *FAULT_Ph - G$_1$ (n)* indicating the phase to ground faults and in the line #1 the coefficient *FAULT_Ph - Ph$_1$ (n)* indicating the phase-to-phase fault in the line #1, the coefficient *FAULT_Ph - G$_2$ (n)* indicating the phase-to-ground faults and in the line #2 the coefficient *FAULT_Ph - Ph$_2$ (n)* indicating the phase-to-phase fault in the line #2, delivered in Step 1, flags ff$_1$ and ff$_2$ are calculated:

for Line #1

$$ff_1(n) = \begin{cases} 1 & when & \begin{cases} f_1(n) \geq f_{thr} & AND & FAULT\_Ph - Ph_1(n) = 1 \\ & OR & \\ f_{01}(n) \geq f_{thr} & AND & FAULT\_Ph - G_1(n) = 1 \end{cases} \\ 0 & otherwise \end{cases}$$

and for Line #2:

$$ff_2(n) = \begin{cases} 1 & when \\ 0 & otherwise \end{cases} \quad \begin{cases} f_2(n) \geq f_{thr} & AND \quad FAULT\_Ph - Ph_2(n) = 1 \\ & OR \\ f_{02}(n) \geq f_{thr} & AND \quad FAULT\_Ph - G_2(n) = 1 \end{cases}$$

where

$f_{thr}$ - the threshold for fault *coefficients* $f_1$, $fi_{01}$, $f_2$, $f_{02}$,
FAULT_Ph - $G_1$ *(n)* is a fault type coefficient indicating phase-to-ground faults and in the line #1
FAULT_Ph - $Ph_1$ *(n)* is a fault type coefficient indicating phase-to-phase fault in the line #1,
FAULT_Ph - $G_2$ *(n)* is a fault type coefficient indicating the phase-to-ground faults and in the line #2,
FAULT_Ph - $Ph_2$ *(n)* is a fault type coefficient indicating the phase-to-phase fault in the line #2.

Next, it is checked if only one of the flags $ff_1$ or $ff_2$ equals one. This condition is described by the following equation:

$$ff_1(n)=1 \;\; AND \;\; ff_2(n)=1 \qquad then \;\; ff_1(n)=0 \;\; AND \;\; ff_2(n)=0,$$

$$or$$

$$ff_1(n)=0 \;\; AND \;\; ff_2(n)=0,$$

it means that an outside fault of the parallel lines is identified;
when

$$ff_1(n)=1 \;\; AND \;\; ff_2(n)=0$$

it means that an internal fault within line # 1 of the parallel lines is identified; when

$$ff_1(n)=0 \;\; AND \;\; ff_2(n)=1$$

it means that an internal fault within line # 2 of the parallel lines has been identified.
In the embodiment of the invention, the threshold for coefficients $f_1$, $fi_{01}$, $f_2$, $f_{02}$ was set to ($f_{thr}$ = 1.5). This threshold is set according to the system configuration.
The value of the flag $ff_1$, and $ff_2$ zero or one is a conventional value and the inverse possibility of the selection is contained in the scope of the invention.

STEP 9

In the next step S9, flags $ff_1$, $ff_2$ available in each of the modules M1...M4 are transmitted to the display or to printing devices which are connected with one of the modules and which are not shown in the drawing. This information is presented to the user of the protective device 2 and is further processed in order to assure the reliable operation of the protective device 2.

**Claims**

1. A method for selecting between internal and external faults in parallel lines, using one-end measurements, where selection functions are implemented by a protective device (2) located at one end of the parallel lines, and where the method contains: measurement of current signals at one end of the line in terminal A or in terminal B, processing of measuring data, determination of pre-fault and fault current signals and the zero-sequence current signal, obtaining current phasors $(I_{A1}, I_{B1}, I_{C1}, I_{A2}, I_{B2}, I_{C2}, I_{01}, I_{02})$, **characterised in that** that the method further comprises the steps of:

- determination of a symmetrical scaling coefficient $(k_{prefault})$ establishing a reciprocal relation between the currents of a single line of the parallel lines,
- determination of the corrected fault current phasors after scaling and calculation of current differences sum for each line *(sdi1, sdi01, sdi2, sdi02)*,
- determination of fault $f_1$, $f_{i01}$, $f_2$, $f_{02}$ coefficients,
- determination a the value of flags $ff_1$ and $ff_2$, having the conventional value one or zero, in order to carry out the selection between faulted and healthy circuits in parallel lines when the following conditions are fulfilled:

for Line #1:

$$ff_1(n) = \begin{cases} 1 & when & \begin{cases} f_1(n) \geq f_{thr} & AND & FAULT\_Ph - Ph_1(n) = 1 \\ & OR & \\ f_{01}(n) \geq f_{thr} & AND & FAULT\_Ph - G_1(n) = 1 \end{cases} \\ 0 & otherwise \end{cases}$$

and for Line #2:

$$ff_2(n) = \begin{cases} 1 & when & \begin{cases} f_2(n) \geq f_{thr} & AND & FAULT\_Ph - Ph_2(n) = 1 \\ & OR & \\ f_{02}(n) \geq f_{thr} & AND & FAULT\_Ph - G_2(n) = 1 \end{cases} \\ 0 & otherwise \end{cases}$$

where

$f_{thr}$ - the threshold for fault coefficients $f_1$, $f_{01}$, $f_2$, $f_{02}$
$n$ - is the real consecutive number of the present digital sample processed by the protective device,
$FAULT\_Ph - G_1$ $(n)$ is a fault type coefficient indicating phase-to-ground faults and in the line #1
$FAULT\_Ph - Ph_1$ $(n)$ is a fault type coefficient indicating a phase-to-phase fault in the line #1,
$FAULT\_Ph - G_2$ $(n)$ is a fault type coefficient indicating phase-to-ground faults and in the line #2,
$FAULT\_Ph - Ph_2$ $(n)$ is a fault type coefficient indicating a phase-to-phase fault in the line #2
and next a selection is performed in the following actions:

- first it is checked if only one of the flags $ff_1$ or $ff_2$ equals one, and if :

$$ff_1(n)=1 \ \ AND \ \ ff_2(n)=1 \quad then \ \ ff_1(n)=0 \ \ AND \ \ ff_2(n)=0,$$

$$or$$

$$ff_1(n)=0 \ \ AND \ \ ff_2(n)=0,$$

it means that an outside fault of the parallel lines has been identified;
- next the relation between the value of $ff_1$ and $ff_2$ is checked, and if

$$ff_1(n)=1 \ \ AND \ \ ff_2(n)=0,$$

it means that an internal fault within line # 1 of the parallel lines has been identified;
or if

$$ff_1(n)=0 \quad \text{AND} \quad ff_2(n)=1,$$

it means that an internal fault within line # 2 of the parallel lines has been identified.

● automatic presentation of the results to the user by the protective device.

2. A method according to claim 1, **characterised in that** the symmetrical scaling coefficient $k_{prefault}$ is calculated in the following way:

$$k_{prefault} = \frac{\left|I_{ABC1pre}\right|}{\left|I_{ABC2pre}\right|}$$

where
$I_{ABC1pre}$, is the value of the positive sequence currents of one of the parallel lines,
$I_{ABC2pre}$ is the value of the positive sequence currents of the other one of the parallel lines.

3. A computer program for selecting between faulted and healthy circuits in parallel lines using one-end measurements which is loadable into and executable on a data processing unit and which computer program, when being executed, performs the steps according to one of the preceding claims.

4. A system for selecting between faulted and healthy circuits in parallel lines, using one-end measurements, having a protective device (2) with a processor (P), located at one end of the parallel lines and with a functional module (M1) for storing data delivered from an on-line measurement (M1), with a calculating module (M3) for doing calculation operations and with an information module (M4) for presenting the result of the inventive method, **characterised in that** the protective device (2) has a selection module (M2) for performing the actions according to any of the method claims, which is connected with the other modules (M1, M3, M4).

5. A system according to claim 3, **characterised in that** the protective device (2) has a form of a protection relay.

Fig. 1.

$I_{AL1}$, $I_{BL1}$, $I_{CL1}$, $I_{AL2}$, $I_{BL2}$, $I_{CL2}$ $I_{0L1}$, $I_{0L2}$

or

$i_{A1}$, $i_{B1}$, $i_{C1}$, $i_{A2}$, $i_{B2}$, $i_{C2}$, $i_{01}$, $i_{02}$,

$M_1$

$f_{thr} \longrightarrow$

$t_F \longrightarrow$

$\longleftarrow FAULT \_ Ph - G(n)_1,$
$\longleftarrow FAULT \_ Ph - Ph(n)_1$
$\longleftarrow FAULT \_ Ph - G(n)_2,$
$\longleftarrow FAULT \_ Ph - Ph(n)_2$

$M_2$

B1

$I_{A1}$, $I_{B1}$, $I_{C1}$, $I_{A2}$, $I_{B2}$, $I_{C2}$, $I_{01}$, $I_{02}$

B2

$k_{prefault}$
$f_1$, $f_{i01}$, $f_2$, $f_{02}$

B3

Internal_Fault

$M_3$　　　$M_4$

Fig. 2

$I_{AL1}, I_{BL1}, I_{CL1}, I_{AL2}, \overleftarrow{I_{BL2}}, I_{CL2} I_{0L1}, I_{0L2}$

or

$i_{A1}, i_{B1}, i_{C1}, i_{A2}, i_{B2}, i_{C2}, i_{01}, i_{02},$

$sdi_{thr} \longrightarrow$

S1

$\longleftarrow FAULT\_Ph - G(n),$
$\longleftarrow FAULT\_Ph - Ph(n)$

$t_F \longrightarrow$

S2

$I_{A1}, I_{B1}, I_{C1}, I_{A2}, I_{B2}, I_{C3}, I_{01}, I_{02},$

S3

$I_{FA1}, I_{FB1}, I_{FC1}, I_{FA2}, I_{FB2}, I_{FC3}, I_{F01}, I_{F02}$ | $I_{A1pre}, I_{B1pre}, I_{C1pre}, I_{A2pre}, I_{B2pre}, I_{C2pre}, I_{01pre}, I_{02pre},$

S4

$k_{prefaut}$

S5

$di_A, di_B, di_C, di_0,$

S6

$sdi_1, sdi_{01}, sdi_2, sdi_{02}$

S7

$f_1, f_{i01}, f_2, f_{02}$

S8

$ff_1, ff_2$

S9

Fig. 3

# EP 2 544 014 A1

Europäisches
Patentamt
European
Patent Office
Office européen
des brevets

## EUROPEAN SEARCH REPORT

**Application Number**

EP 11 46 0033

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHANG QINGCHAO ET AL: "Fault Location of Two-parallel Transmission Line for Non-earth Fault Using One-terminal Data", IEEE TRANSACTIONS ON POWER DELIVERY, IEEE SERVICE CENTER, NEW YORK, NY, US, vol. 14, no. 3, 1 July 1999 (1999-07-01), pages 863-867, XP011089105, ISSN: 0885-8977, DOI: 10.1109/61.772325 * the whole document * | 1-5 | INV. G01R31/08 |
| A | OSMAN A H ET AL: "Experimental test results for a parallel transmission lines protection scheme using wavelet transform", IEE PROCEEDINGS: GENERATION, TRANSMISSION AND DISTRIBUTION, INSTITUTION OF ELECTRICAL ENGINEERS, GB, vol. 151, no. 6, 12 November 2004 (2004-11-12), pages 713-720, XP006023081, ISSN: 1350-2360, DOI: 10.1049/IP-GTD:20041071 * the whole document * | 1-5 | |
| A | US 5 661 664 A (NOVOSEL DAMIR [US] ET AL) 26 August 1997 (1997-08-26) * the whole document * | 1-5 | TECHNICAL FIELDS SEARCHED (IPC) G01R |
| A,D | US 6 476 613 B2 (SAHA MURARI MOHAN [SE] ET AL) 5 November 2002 (2002-11-05) * the whole document * | 1-5 | |

The present search report has been drawn up for all claims

| Place of search | Date of completion of the search | Examiner |
|---|---|---|
| Munich | 10 February 2012 | Dogueri, Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

15

**ANNEX TO THE EUROPEAN SEARCH REPORT
ON EUROPEAN PATENT APPLICATION NO.**

EP 11 46 0033

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2012

| Patent document cited in search report | | Publication date | Patent family member(s) | | Publication date |
|---|---|---|---|---|---|
| US 5661664 | A | 26-08-1997 | CA<br>US<br>WO | 2184091 A1<br>5661664 A<br>9524014 A2 | 08-09-1995<br>26-08-1997<br>08-09-1995 |
| US 6476613 | B2 | 05-11-2002 | NONE | | |

EPO FORM P0459

For more details about this annex : see Official Journal of the European Patent Office, No. 12/82

**REFERENCES CITED IN THE DESCRIPTION**

**Patent documents cited in the description**

- US 4525098 A
- US 6476613 B